Europäisches Patentamt

European Patent Office

Office européen des brevets

(19)

(11) Veröffentlichungsnummer : **0 411 359 B1**

(12) # EUROPÄISCHE PATENTSCHRIFT

(45) Veröffentlichungstag der Patentschrift :
26.08.92 Patentblatt 92/35

(51) Int. Cl.$^5$ : **G01B 21/08**, C23C 14/54, C23C 14/04

(21) Anmeldenummer : **90113313.2**

(22) Anmeldetag : **12.07.90**

(54) Anordnung zur Dickenmessung von Dünnschichten.

(30) Priorität : **02.08.89 DE 3925536**

(43) Veröffentlichungstag der Anmeldung :
06.02.91 Patentblatt 91/06

(45) Bekanntmachung des Hinweises auf die
Patenterteilung :
26.08.92 Patentblatt 92/35

(84) Benannte Vertragsstaaten :
CH DE FR GB LI NL SE

(56) Entgegenhaltungen :
DE-A- 2 932 483

(56) Entgegenhaltungen :
FR-A- 2 513 661
GB-A- 2 145 741
US-A- 4 096 821
PATENT ABSTRACTS OF JAPAN Band 11, Nr.
193 (C-430)(2640), 20. Juni 1987; & JP - A -
6217046 (NEC CORP.) 26.01.1987

(73) Patentinhaber : **LEYBOLD
AKTIENGESELLSCHAFT
Wilhelm-Rohn-Strasse 25, Postfach 1555
W-6450 Hanau am Main 1 (DE)**

(72) Erfinder : **Wurczinger, Hans-Dieter
Alte Strasse 31
W-6368 Bad Vilbel (DE)**

## Beschreibung

Die Erfindung betrifft eine Kathodenzerstänbungsanlage mit einer Anordnung zur Dickenmessung von Dünnschichten, die gleichzeitig mit der Beschichtung von durch die Prozeßkammer geförderten Werkstücken auf diesen oder auf Substraten aufbringbar sind, wobei die Dickenmessung durch Erfassung des Transmissions-, Reflektions- oder Widerstandsverhaltens oder aber durch mechanisches Ausmessen der Dünnschicht erfolgt.

Es ist ein Testglashalter für die optische Messung von Schichteigenschaften bekannt (DE 29 32 483) mit mehreren äquidistant auf einem Kreis innerhalb einer Platine angeordneten Ausnehmungen für Testgläser. Mittels einer Antriebswelle kann jeweils eines der Testgläser in den Strom eines Beschichtungsmaterials und in einen Meßlichtstrahl geschwenkt werden, wobei jedes der Testgläser einem bestimmten Beschichtungsmaterial zugeordnet ist, damit auf dem gleichen Testglas absatzweise stets das gleiche Beschichtungsmaterial niedergeschlagen wird. Der Testglashalter ist für Vakuumbeschichtungsanlagen mit einem um eine zentrale Achse drehbaren Karussell mit mindestens einem Substrathalter vorgesehen, der in voneinander getrennten Positionen unterschiedlichen Beschichtungsmaterialien aussetzbar ist. Zur Lösung der Aufgabe, die Drehung bzw. Weiterschaltung der Testgläser bei einer Drehung bzw. Weiterschaltung des Substrathalters in eine andere Beschichtungsposition automatisch durchführen zu können, wird dazu vorgeschlagen, daß die Antriebswelle der Platine für die Testgläser mit einem ersten Antriebsrad versehen ist, welches mit einem zweiten zur zentralen Achse konzentrischen Antriebsrad gekoppelt ist, wobei das Übersetzungsverhältnis so gewählt ist, daß bei einem Transport des Substrathalters in eine andere Position jeweils ein anderes Testglas in den Strom des Beschichtungsmaterials und in den Meßlichtstrahl geschwenkt wird. Auf die angegebene Weise wird der Testglashalter zwangsläufig mit dem Karussell des Substrathalters gekoppelt, so daß eine falsche Korelation ausgeschlossen wird.

Der vorliegenden Erfindung liegt nun die Aufgabe zugrunde eine Kathodenzerstänbungsanlage mit einer Anordnung zur Dickenmessung von Dünnschichten zu schaffen, die die laufende Überwachung der einzelnen Schichten eines Schichtpakets ermöglicht und zwar bei einem Beschichtungsprozeß, bei dem die einzelnen Werkstücke oder Substrate beispielsweise ein Band kontinuierlich durch die Beschichtungskammer hindurchlaufen und dabei mehrere Beschichtungsquellen oder -Stationen passieren.

Erfindungsgemäß wird diese Aufgabe bei einer Kathodenzerstänbungsanlager der eingangs genannten Art dadurch gelöst, daß in der Prozeßkammer mehrere Kathodenanordnungen hintereinanderliegend vorgesehen sind, die die zu zerstäubenden Targets aufweisen, wobei Blenden zwischen den Targets und den Werkstücken gehalten sind, die jeweils neben ihren zentralen Öffnungen für den Durchtritt des Stroms des Beschichtungsmaterials jeweils eine weitere fensterförmige Ausnehmung im Bereich des Materialstroms quer zur Substratförderrichtung zueinander versetzt angeordnet sind und so auf den an den Kathodenanordnungen vorbeigeforderten Werkstücken oder besonderen Testsubstraten nebeneinanderliegende Teststreifen erzeugen, die jeweils einer einzigen Schicht eines auf dem Substrat oder Werkstück erzeugten Schichtpakets entsprechen.

Vorzugsweise ist die auf der Randpartie der Blende der ersten Kathodenanordnung vorgesehene fensterförmige Ausnehmung um ein geringes Maß quer zur Substratförderrichtung versetzt gegenüber der fensterförmigen Ausnehmung der Blende der zweiten Kathodenanordnung angeordnet, wobei die Ausnehmung in der Blende der ersten Kathodenanordnung unmittelbar an der Innenkante der von der Blende gebildeten zentralen Öffnung vorgesehen ist.

Mit Vorteil sind eine Vielzahl von Kathodenanordnungen in einer oder mehreren hintereinanderliegenden Prozeßkammern vorgesehen, wobei jeder Kathodenanordnung eine Blende mit jeweils einer fensterförmigen Ausnehmung zugeordnet ist und wobei alle Ausnehmungen quer zur Substratförderrichtung versetzt zueinander angeordnet sind und jede Ausnehmung während der Erzeugung des Schichtpakets einen eigenen Teststreifen auf dem Werkstück selbst oder auf einem jeweils neben diesem angeordneten besonderen Testsubstrat erzeugt.

In einer bevorzugten Ausführungsform befinden sich die fensterförmigen Ausnehmungen und damit auch die Teststreifen auf der einen Seite des Werkstücks bzw. Substrats; es ist selbstverständlich auch möglich einen Teil der Ausnehmungen auf der gegenüberliegenden Seite der Blenden der Beschichtungsstationen bzw. Kathodenanordnungen vorzusehen.

Ein Ausführungsbeispiel der Erfindung ist in der Zeichnung dargestellt und wird im folgenden näher beschrieben. Es zeigen:

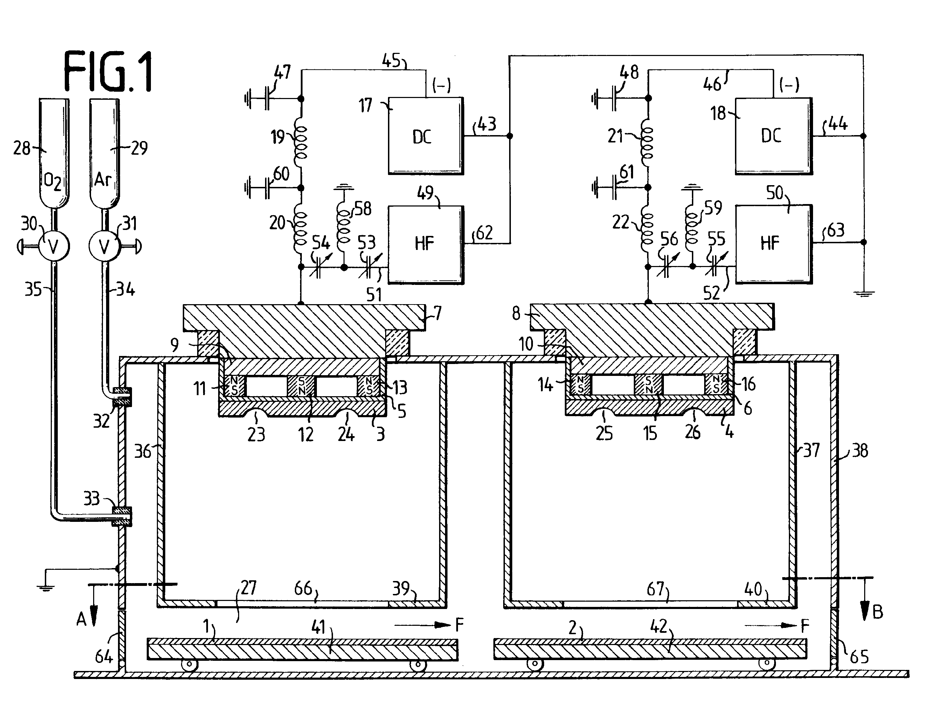

Fig.1 eine Prinzipdarstellung einer erfindungsgemäßen Anordnung mit zwei Beschichtungsstationen bzw. Kathodenanordnungen und mit Werkstücken, die von auf Schienen gleitenden Substratschlitten gehalten sind und die Werkstücke von der ersten zur nächsten Beschichtungsstation transportieren, wobei in den einander gegenüberliegend angeordneten Wänden der Beschichtungskammer Schleusen vorgesehen sind, die in der Zeichnung nicht näher dargestellt sind.

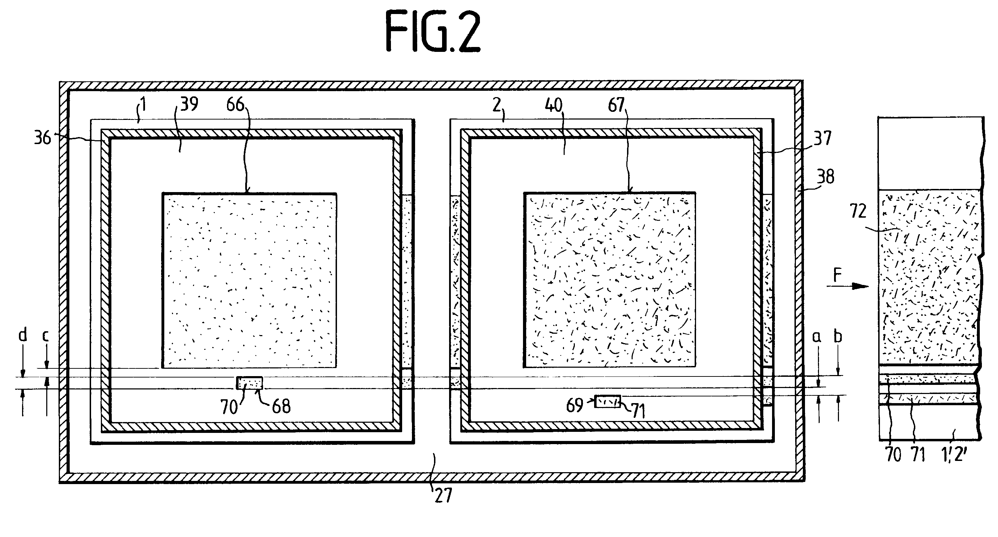

Fig.2 den Schnitt durch die Anordnung nach Fig. 1 gemäß den Linien A-B mit der Ansicht der Blenden der beiden Kathodenanordnungen und mit in den Blenden neben ihren zentralen Öffnungen für den Durchtritt des Stroms von Beschichtungsmaterial angeordneten fensterförmigen Ausnehmungen zur Erzeugung von Teststreifen.

In Fig.1 sind Substrate 1,2 dargestellt, die auf Substrathaltern 41,42 angeordnet sind, die auf Rollen bewegbar sind, und die mit dünnen Schichten versehen werden sollen. Diesen Substraten 1,2 liegen Targets 3,4 gegenüber, die zu zerstäuben sind. Die Targets 3,4 stehen über im Schnitt U-förmige Elemente 5,6 mit Elektroden 7,8 in Verbindung, die jeweils auf einem Joch 9,10 ruhen, welches zwischen sich und den Elementen 5,6 jeweils drei Dauermagnete 11,12,13 bzw. 14,15,16 einschließt. Die auf die Targets 3,4 gerichteten Polaritäten der Pole der drei Dauermagnete wechseln sich ab, so daß jeweils die Südpole der beiden äußeren Dauermagnete 11,13 bzw. 14,16 mit dem Nordpol des mittleren Dauermagneten 12 bzw. 15 ein etwa kreisbogenförmiges Magnetfeld durch das jeweilige Target 3,4 bewirken. Dieses Magnetfeld verdichtet das Plasma vor dem Target 3,4, so daß es dort, wo die Magnetfelder das Maximum ihres Kreisbogens besitzen, seine größte Dichte hat. Die Ionen im Plasma werden durch ein elektrisches Feld beschleunigt, das sich aufgrund einer Gleichspannung aufbaut, die von einer Gleichstromquelle 17,18 abgegeben wird. Diese Gleichstromquelle 17,18 ist jeweils mit ihrem negativen Pol über zwei Induktivitäten 19,20 bzw. 21,22 mit der Elektrode 7 bzw. 8 verbunden. Das elektrische Feld steht jeweils senkrecht auf der Oberfläche des Targets 3 bzw. 4 und beschleunigt die positiven Ionen des Plasmas in Richtung auf dieses Target. Hierdurch werden mehr oder weniger viele Atome oder Partikel aus dem Target 3 bzw. 4 herausgeschlagen, und zwar insbesondere aus den Gebieten 23,24 bzw. 25,26 wo die Magnetfelder ihre Maxima haben. Die zerstäubten Atome oder Partikel wandern in Richtung auf das Werkstück oder Substrat 1 bzw. 2, wo sie sich als dünne Schichten niederschlagen.

Handelt es sich bei dem Targetmaterial um ein Metall und soll auf dem Substrat eine Oxidschicht abgeschieden werden, so reagieren die aus den Targets 3,4 herausgeschlagenen Partikel in einem Raum 27 mit bestimmten Gasen, die aus Gasbehältern 28,29 über Ventile und Einlaßstutzen 32,33 mittels Gaszuführungsleitungen 34,35 in diesen Raum geleitet werden. Dieser Raum 27 wird durch drei Behälter 36,37,38 gebildet, von denen der eine Behälter 38 die Substrate 1,2 mitumfaßt, während die anderen beiden Behälter 36,37 vor den Substraten 1,2 enden und zwei Blenden 39,40 bilden. Beide Behälter 36,37 und damit auch die Substrate 1,2 die auf den Substrathaltern 41,42 ruhen, liegen elektrisch auf Masse. An Masse liegen auch die Anschlüsse 43,44 der Gleichstromquellen 17,18, deren erste Anschlüsse 45,46 außer an die Induktivitäten 19,21 bzw. 20,22 auch noch an Kondensatoren angeschlossen sind, die ihrerseits an Masse liegen.

Außer den Gleichstromquellen 17,18 sind auch noch zwei Hochfrequenzquellen 49,50 mit Anschlüssen 51,52 mit den Elektroden 7,8 elektrisch verbunden und zwar jeweils über zwei regelbare Kondensatoren 53,54 bzw. 55,56 zwischen denen noch jeweils eine Induktivität 58,59 angeschlossen ist, die an Masse liegt. Der Verbindungspunkt der beiden anderen Induktivitäten 19,20 bzw. 21,22 ist jeweils an einen Kondensator 60,61 angeschlossen, der - wie auch die zweiten Anschlüsse 62,63 der Hochfrequenzquellen 49,50 - ebenfalls an Masse liegt.

Die Kapazitäten 47,60 und 48,61 sowie die eingeschlossenen Induktivitäten 19,21 bilden Tiefpaßfilter, die hohe Frequenzen am Durchtritt hindern. Die Induktivitäten 20,22 unterstützen noch diese Wirkung. Die Kapazitäten 53,54 und 55,56 sowie die Induktivitäten 58,59 bilden ein Anpassungsnetzwerk für die Hochfrequenzeinspeisung zu den Kathoden 7,8. Gleichzeitig wirken sie als Hochpaßfilter, d.h. die Gleichspannung kann nicht zu den Wechselstromquellen 49,50 gelangen.

Das Gas gelangt zwar in den Zwischenraum zwischen dem ersten Behälter 38 und den zweiten Behältern 36,37, doch könnte es auch über ein die Kathoden 7,8 umgebendes Gasverteilungssystem den zweiten Behältern 36,37 unmittelbar zugeführt werden.

Für die Steuerung der dargestellten Anordnung kann ein Prozeßrechner vorgesehen werden, der Meßdaten verarbeitet und Steuerungsbefehle abgibt. Diesem Prozeßrechner können beispielsweise die Werte des gemessenen Partialdrucks in der Prozeßkammer 27 zugeführt werden. Aufgrund dieser und anderer Daten kann er zum Beispiel den Gasfluß über die Ventile 30,31 regeln und die Kombination aus Gleich- und Wechselspannung an den Kathoden 7,8 einstellen. Der Prozeßrechner ist auch in der Lage, alle anderen Variablen, zum Beispiel Kathodenstrom, Hochfrequenzleistung und magnetische Feldstärke zu regeln. Da derartige Prozeßrechner bekannt sind, wird auf eine Beschreibung ihres Aufbaus verzichtet.

Es ist nicht im einzelnen dargestellt, wie die Hochfrequenz-Versorgung intern geregelt wird. Es ist jedoch bekannt, einen Regelkreis so aufzubauen, daß bei einer bestimmten Sollwertvorgabe die abgegebene Leistung auf diesen vorgegebenen Wert konstant geregelt wird.

Bei der in der (Zeichnung) Fig.1 dargestellten Anordnung zum Beschichten von Substraten 1,2 mit zwei Gleichstromquellen 17,18 und mit zwei zusätzlichen Wechselstromquellen 49,50, deren Ausgangsspannungen den Gleichstromquellen 17,18 überlagert sind, ist die elektrische Leistung der Wechselstromquellen 49,50, die den Elektroden zugeführt wird so bemessen, daß sie 5% bis 25% der von den Gleichstromquellen 17,18 den Elektroden 7,8 zugeführten Leistung entspricht. Anstelle einer Anordnung mit Gleich- und Wechselstromquellen können aber auch ausschließlich Gleich- oder Wechselstromquellen vorgesehen werden, da ihre Ausbildung hinsichtlich der erfindungsgemäßen Anordnung für die Dickenmessung der aufgesputterten Schichten unabhängig ist. Ebenso können mehr als nur zwei Beschichtungsquellen vorgesehen sein, an denen die Substrate vorbeigeführt werden, um von ihnen beschichtet zu werden.

Wie Fig.2 zeigt, bilden die beiden Blenden 39,40 nicht nur jeweils zentrale Öffnungen 66,67 sondern sind auch jeweils mit kleinen fensterförmigen Ausnehmungen 68,69 versehen, die jedoch um das Maß a versetzt zueinander angeordnet sind und die beide die Breite b aufweisen, wobei die erste Ausnehmung 68 um das Maß c von der Innenkante der zentralen Öffnung 66 entfernt angeordnet ist.

Während des Beschichtungsvorgangs laufen die Substrate 1,2 über die Schleuse 64 in die Prozeßkammer 27 ein, bewegen sich dann in Pfeilrichtung unter den beiden Beschichtungsquellen bzw. Kathodenanordnungen 7,8 hindurch und laufen dann durch die Schleuse 65 aus der Beschichtungskammer 27 hinaus, wobei sie zweckmäßigerweise auf mit Rollen versehenen Substrathaltern 41,42 (carrier) gehalten sind.

Da während des Sputter-Vorgangs ein Teilstrom des von den Targets 3,4 abgestäubten Materials auch durch die fensterförmigen Ausnehmungen 68,69 nach unten zu austritt bzw. durch diese hindurchtritt, befinden sich auf den Substraten 1,2 nach beendetem Beschichtungsvorgang zwei nebeneinanderliegende streifenförmige Beschichtungen, von denen der eine Beschichtungsstreifen der ersten Dünnschicht im Bereich der zentralen Öffnung 66 und der andere Beschichtungsstreifen der zweiten Dünnschicht im Bereich der zentralen Öffnung 67 entspricht (während also am Werkstück 1 bzw. 2 die Schichten übereinander liegen, liegen die Probeschichten nebeneinander, so daß nach dem Austritt der Substrate aus der Beschichtungskammer 38 eine Beurteilung bzw. Messung beider Schichten anhand der Probestreifen auf den Substraten 1,2 vorgenommen werden kann). Es ist klar, daß für die Erzeugung der Teststreifen d.h. der über die fensterförmigen Ausnehmungen 68,69 in den Blenden 39,40 erzeugten Schichten besondere auf den Substrathaltern 41,42 neben den Werkstücken aufgelegte Testsubstrate vorgesehen werden können. Bei der in den Zeichnungen dargestellten Anordnung würde dann jedes Testsubstrat nach dem Durchlauf der Prozeßkammer 27 zwei Teststreifen aufweisen, während das nebenliegende Werkstück selber mit einem Zwei-Schicht-Paket versehen ist.

Wie Fig. 2 zeigt, hat ein Substrat 1' bzw. 2' mit einem Schichtpaket 72 versehen die Prozeßkammer 27 in Pfeilrichtung F durch die Schleuse 65 verlassen und ist über die fensterförmige Ausnehmung 68 mit einem Teststreifen 70 und über die fensterförmige Ausnehmung 69 mit einem Teststreifen 71 versehen worden. Die beiden Teststreifen können jetzt einzeln geprüft werden, wobei deren Beschaffenheit auf die Qualität des Schichtpakets 72 schließen läßt.

## Patentansprüche

1. Kathodenzestänbungsanlage mit einer Anordnung zur Dickenmessung von Dünnschichten, die gleichzeitig mit der Beschichtung von durch eine Prozeßkammer (27) geförderten Werkstücken (1,2) auf diesen oder auf Testsubstraten aufbringbar sind, wobei die Dickenmessung durch Erfassung des Transmissions-, Reflektions- oder Widerstandsverhaltens oder aber durch mechanisches Ausmessen der Dünnschicht erfolgt, dadurch gekennzeichnet, daß in der Prozeßkammer (27) mehrere Kathodenanordnungen (7,8) hintereinanderliegend vorgesehen sind, die die zu zerstäubenden Targets (3,4) aufweisen, wobei Blenden (39,40) zwischen den Targets (3,4) und den Werkstücken (1,2) gehalten sind, die jeweils neben ihren zentralen Öffnungen (66,67) für den Durchtritt des Stroms des Beschichtungsmaterials jeweils eine weitere fensterförmige Ausnehmung (68,69) im Bereich des Materialstroms aufweisen, die quer zur Substratförderrichtung (F) zueinander versetzt angeordnet sind und so auf den an den Kathodenanordnungen (7,8) vorbeigeförderten Werkstücken oder besonderen Testsubstraten nebeneinanderliegende Teststreifen (70,71) erzeugen, die jeweils einer einzigen Schicht eines auf dem Substrat oder Werkstück (1,2) erzeugten Schichtpakets (72) entsprechen.

2. Kathodenzerstänbungsanlage nach Anspruch 1, dadurch gekennzeichnet, daß die auf der Randpartie der Blende (39) der ersten Kathodenanordnung (7) vorgesehene fensterförmige Ausnehmung (68) um ein geringes Maß (a) quer zur Substratförderrichtung (F) versetzt gegenüber der fensterförmigen Ausnehmung (69) der Blende (40) der folgenden Kathodenanordnung (8) angeordnet ist, wobei die Ausnehmung (68) in der Blende (39) der ersten Kathodenanordnung (7) unmittelbar an der Innenkante der von der Blende (39) gebildeten zentralen Öffnung (66) vorgesehen ist.

3. Kathodenzerstänbungsanlage nach den Ansprüchen 1 und 2, dadurch gekennzeichnet, daß eine Vielzahl von Kathodenanordnungen (7,8,...) in einer oder mehreren hintereinanderliegenden Prozeßkammern (27,...) vorgesehen sind, wobei jeder Kathodenanordnung (7,8) eine Blende (39,40,...) mit jeweils einer fensterförmigen Ausnehmung (68,69,...) zugeordnet ist und wobei alle Ausnehmungen (68,69,...) quer zur Substratförderrichtung (F) versetzt zueinander angeordnet sind und jede Ausnehmung während der Erzeugung des Schichtpakets einen eigenen Teststreifen (71,72...) auf dem Werkstück (1,2,...bzw. 1′,2′) selbst oder auf einem jeweils neben diesem angeordneten besonderen Testsubstrat erzeugt.

## Claims

1. A cathode sputtering unit comprising an arrangement for measuring the thickness of thin layers which, simultaneously to the coating of workpieces (1, 2) conveyed through a process chamber (27), can be applied to said workpieces or to test substrates, wherein the thickness measurement is carried out by detecting the transmission-, reflection- or resistance behaviour or by mechanical measurement of the thin layer, characterised in that in the process chamber (27) a plurality of cathode arrangements (7, 8) are disposed in series, which cathode arrangements comprise the targets (3, 4) which are to be sputtered, masks (39, 40) being fixed between the targets (3, 4) and the workpieces (1, 2), said masks each comprising, in addition to their central openings (66, 67) for the passage of the stream of coating material, a respective further, window-like opening (68, 69) in the region of the material stream, which are disposed so as to be offset with respect to one another transversely to the direction of conveyance (F) of the substrate and thus produce test strips (70, 71), disposed one beside another, on the workpieces or separate test substrates which are conducted past the cathode arrangements (7, 8), where said test strips each correspond to one single layer of a stack (72) of layers produced on the substrate or workpiece (1, 2).

2. A cathode sputtering unit as claimed in Claim 1, characterised in that the window-like opening (68) provided in the margin zone of the mask (39) of the first cathode arrangement (7) is disposed so as to be offset with respect to the window-like opening (69) of the mask (40) of the following cathode arrangement (8) by a small amount (a) transversely to the direction of conveyance (F) of the substrate, where the opening (68) in the mask (39) of the first cathode arrangement (7) is provided directly at the inner edge of the central opening (66) formed by the mask (39).

3. A cathode sputtering unit as claimed in Claims 1 and 2, characterised in that a plurality of cathode arrangements (7, 8,...) are provided in one or more serially disposed process chambers (27,...), where each cathode arrangement (7, 8) is assigned a mask (39, 40,...) comprising a respective window-like opening (68, 69,...) and where all the openings (68, 69,...) are arranged so as to be offset with respect to one another transversely to the direction of conveyance (F) of the substrate and during the formation of the stack of layers each opening produces an individual test strip (71, 72...) on the workpiece (1, 2,.. or 1′, 2′) itself or on a respective, separate test substrate arranged beside the workpiece.

## Revendications

1. Installation de pulvérisation cathodique comportant un dispositif pour mesurer l'épaisseur de couches minces applicables simultanément sur des pièces (1, 2) ou sur des substrats de test, lors du recouvrement de ces pièces avec de telles couches pendant qu'elles sont transportées à travers une chambre de traitement (27), la mesure de l'épaisseur s'effectuant par la détermination du comportement de transmission, de réflexion ou de résistance ou alors par la mesure mécanique de la couche mince, caractérisée en ce que plusieurs dispositifs cathodiques (7, 8), présentant les cibles (3, 4) à pulvériser, sont placés l'un derrière l'autre dans la chambre de traitement (27) et des diaphragmes (39, 40), supportés entre les cibles (3, 4) et les pièces (1, 2), possèdent chacun, à côté de leurs ouvertures centrales (66, 67) pour le passage du flux de matériau à déposer, un ajour supplémentaire en forme de fenêtre (68, 69), située dans la zone du flux de matériau, les ajours supplémentaires étant disposés avec un décalage mutuel transversalement à la direction (F) de transport des substrats et produisant ainsi, sur les pièces ou sur des substrats de test particuliers transportés devant les dispositifs cathodiques (7, 8), des bandes de test (70, 71) juxtaposées qui correspondent chacune à une seule couche d'un empilement de couches (72) produit sur le substrat ou la pièce (1, 2).

2. Installation de pulvérisation cathodique selon la revendication 1, caractérisée en ce que l'ajour en forme de fenêtre (68) prévu dans la partie marginale du diaphragme (39) du premier dispositif cathodique (7), est disposé avec un faible décalage (a), transversalement à la direction (F) de transport des substrats, par rapport à l'ajour en forme de fenêtre (69) du diaphragme (40) du dispositif cathodique (8) suivant, l'ajour (68) du diaphragme (39) du premier dispositif cathodique (7) étant placé directement à côté du bord intérieur de l'ouverture centrale (66) formée par le diaphragme (39).

3. Installation de pulvérisation cathodique selon les revendications 1 et 2, caractérisée en ce qu'un grand nombre de dispositifs cathodiques (7, 8,...) est prévu dans une chambre ou dans plusieurs chambres de traitement (27,...) situées l'une derrière l'autre, avec coordination à chaque dispositif cathodique (7, 8) d'un diaphragme (39, 40,...) présentant un ajour en forme de fenêtre (68, 69,..,), tous les ajours (68, 69,...) étant mutuellement décalés transversalement à la direction (F) de transport des substrats et chaque ajour produisant, pendant la formation de l'empilement de couches, une bande de test (71, 72,...) qui lui est propre sur la pièce (1,2,... ou 1′, 2′) elle-même ou sur un substrat de test particulier disposé à côté de la pièce.

FIG.1

EP 0 411 359 B1

FIG.2